# EUROPEAN PATENT APPLICATION

(11) **EP 2 999 010 A1**
(43) Date of publication of application: **23.03.2016**
(21) Application number: 13884472.5
(22) Date of filing: 03.07.2013
(51) Int. Cl.: H01L 31/09

(54) **GRAPHENE QUANTUM DOT PHOTODETECTOR AND MANUFACTURING METHOD THEREFOR**

(30) Priority: 13.05.2013 KR 20130053894
(71) Applicant: University-Industry Cooperation Group of Kyung Hee University, Gyeonggi-do 446-701 (KR)
(72) Inventor: CHOI, Suk Ho, Suwon-si Gyeonggi-do 443-812 (KR); KIM, Sung, Suwon-si Gyeonggi-do 443-472 (KR); KIM, Chang Oh, Seoul 110-840 (KR); SHIN, Dong Hee, Cheonan-si Chungcheongnam-do 331-827 (KR)
(74) Representative: Zeitler Volpert Kandlbinder Patent- und Rechtsanwälte Partnerschaft mbB
(86) International application number: PCT/KR2013/005886
(87) International publication number: WO 2014/185587

(57) **Abstract**

Provided is a graphene photodetector. The graphene photodetector comprises a first graphene, a graphene quantum dot (GQD) layer formed on the first graphene and including a plurality of GQDs and a second graphene provided on the GQD layer.

## Description

### BACKGROUND

### FIELD OF THE INVENTION

The invention relates to a graphene quantum dot (GQD) photodetector and a fabricating method thereof, and more particularly, a photodetector using the physical properties of GQDs and a fabricating method of the photodetector.

### DESCRIPTION OF THE RELATED ART

Since discovered in 2004, graphene, which is a two-dimensional (2D) material consisting of a single layer of carbon atoms, has attracted a great deal of attention due to its unique and extraordinary properties. The 2010 Nobel Prize in Physics was awarded jointly to Andre Geim and Konstantin Novoselov who were the first to separate monoatomic layer graphene, and graphene has been increasingly appreciated, ever since, not only by researchers worldwide, but also by ordinary people.

Graphene is the thinnest, strongest and yet flexible material that has ever been known and is better than any other materials at conducting electricity or heat. Graphene is expected to be used as a structural material or replace silicon (Si), which is commonly used in electronic devices, because of its excellent properties. The use of graphene has been gradually extended to the field of next-generation displays such as flexible displays and touch panels, the field of energy industry such as solar cells, and (RFID), and the like.

Photodetectors, which are photoelectric conversion sensors that convert electromagnetic wave signals such as light into electric signals, are widely used in various fields of industry such as image sensing, communication, chemical/medical/biological sensing, and aerospace industry. Si, germanium (Ge), and indium gallium arsenide (InGaAs), which are of common use in photodetectors, are capable of detecting ultraviolet (UV) light, visible light, and infrared light, respectively. Si and Ge can be driven at room temperature, but have a limited photodetection band and a low optical responsivity, and InGaAs can achieve high-sensitivity performance only when cooled down to a temperature of 4.2 K. With the development of flexible displays, the demand has arisen for a transparent flexible material has arisen. However, Si, Ge, and InGaAs are highly susceptible to heat and are thus difficult to apply to high-temperature growth.

Recent research has been reported on colloidal quantum dot-based photodetectors using colloidal quantum dots such as lead sulfide (PbS), lead selenide (PbSe), cadmium sulfide (CdS), or cadmium selenide (CdSe) quantum dots. The colloidal quantum dot-based photodetectors are relatively simple and inexpensive to fabricate and have a high sensitivity. However, the colloidal quantum dot-based photodetectors have a relatively slow response speed, and have limited commercial applicability because they need a high driving voltage to achieve high gain. Research has also been conducted on vertical photodetectors. However, the vertical photodetectors have a low optical responsivity and a high driving voltage, are not easy to fabricate in large scale, and have a very low detectivity.

### SUMMARY

Graphene-based photodetectors include all the properties of graphene and can thus be configured to be transparent and flexible and to have fast response speed. Accordingly, the graphene-based photodetectors are believed to pave the way for the development of next-generation ultrahigh-speed photodetectors. However, currently-available graphene-based photodetectors have a field effect transistor (FET)-based 3-channel horizontal structure, and generate photocurrent between a source and a drain by adjusting the band gap or Fermi level of graphene using a gate voltage. However, these FET-type photodetectors are complicated and difficult to fabricate, especially in large scale, and have low optical responsivity.

Exemplary embodiments of the invention provide a graphene-based photodetector, which is formed, using techniques of fabricating a large-scale graphene and graphene quantum dots (GQDs), to consist of graphene only, have high detectivity and fast response speed, and have an excellent optical responsivity over a wide band.

Exemplary embodiments of the invention also provide a manufacturing method of a GQD photodetector, in which GQDs are inserted between graphenes so as to provide a GQD photodetector having excellent properties and applicable to a flexible device.

Additional advantages, subjects, and features of the invention will be set forth in part in the description which follows and in part will become apparent to those having ordinary skill in the art upon examination of the following or may be learned from practice of the invention.

According to an aspect of the invention, a graphene photodetector includes a first graphene; a graphene quantum dot (GQD) layer formed on the first graphene and including a plurality of GQDs; and a second graphene provided on the GQD layer.

According to another aspect of the invention, a manufacturing method of a GQD photodetector, includes: forming a first graphene; forming a GQD layer, including GQDs, on the first graphene; and forming a second graphene on the GQD layer so as to fabricate a "first graphene/GQD layer/second graphene" structure.

Other specific items of the embodiments are included in the detailed description and figures.

Exemplary embodiments of the invention have at least the following advantages.

According to exemplary embodiments of the invention, it is possible to provide a graphene-based photodetector, which is formed, using techniques of fabricating a large-scale graphene and graphene quantum dots (GQDs), to consist of graphene only, have high detectivity and fast response speed, and have an excellent optical responsivity over a wide band.

In addition, it is possible to provide a GQD photodetector having excellent properties and applicable to a flexible device, by inserting GQDs between graphenes.

The effects according to the invention may not be limited by the contents disclosed in this specification, and various effects may be included in this specification.

### BRIEF DESCRIPTION OF THE DRAWINGS

The above and other subjects, features and advantages of the invention will be more apparent from the following detailed description taken in conjunction with the accompanying drawings, in which:
FIGS. 1A to 1G are schematic views illustrating the fabrication of graphene quantum dots (GQDs).
FIG. 2 is a schematic view illustrating the bonding of graphene and quantum dots, according to an exemplary embodiment of the invention.
FIG. 3 is a circuit diagram of a graphene/GQD/graphene photodetector according to an exemplary embodiment of the invention, for explaining the photodetection properties of the photodetector.
FIG. 4 is a graph showing photoluminescence (PL) data of the graphene/GQD/graphene photodetector according to an exemplary embodiment of the invention.
FIG. 5 is a current-voltage curve of the graphene/GQD/graphene photodetector according to an exemplary embodiment of the invention.
FIG. 6 shows current-voltage curves of the graphene/GQD/graphene photodetector according to an exemplary embodiment of the invention for various incident energies.
FIG. 7 illustrates the dark current-to-photocurrent ratio and the optical responsivity of the graphene/GQD/graphene photodetector according to an exemplary embodiment of the invention. More specifically, FIG. 7(a) is a graph showing the dark current-to-photocurrent ratio of the graphene/GQD/graphene photodetector according to an exemplary embodiment of the invention, and FIG. 7(b) is a graph showing the optical responsivity of the graphene/GQD/graphene photodetector according to an exemplary embodiment of the invention in response to a forward voltage being applied.
FIG. 8 is a graph showing the spectral responsivity of the graphene/GQD/graphene photodetector according to an exemplary embodiment of the invention.
FIG. 9 is a graph showing the external quantum efficiency of the graphene/GQD/graphene photodetector according to an exemplary embodiment of the invention.
FIG. 10 is a graph showing the detectivity of the graphene/GQD/graphene photodetector according to an exemplary embodiment of the invention.
FIG. 11 illustrates the operating range of the graphene/GQD/graphene photodetector according to an exemplary embodiment of the invention. More specifically, FIG. 11 (a) is a graph showing the linear dynamic range (LDR) of the graphene/GQD/graphene photodetector according to an exemplary embodiment of the invention, and FIG. 11(b) is a graph showing the variation of the LDR of the graphene/GQD/graphene photodetector according to an exemplary embodiment of the invention according to an applied voltage.
FIG. 12 is a graph showing the variation of the optical responsivity of the graphene/GQD/graphene photodetector according to an exemplary embodiment of the invention according to a 3-dB frequency. More specifically, FIG. 12(a) is a graph showing the responsivity of the graphene/GQD/graphene photodetector according to an exemplary embodiment of the invention according to frequency, and FIG. 12(b) is a graph showing the variation of the 3-dB frequency of the graphene/GQD/graphene photodetector according to an exemplary embodiment of the invention according to an applied voltage.
FIG. 13 is a graph showing the periodic variation of photocurrent according to pulse laser light periodically incident upon the graphene/GQD/graphene photodetector according to an exemplary embodiment of the invention.
FIG. 14 is a graph showing the variation of photocurrent over a short period of time in response to pulse laser light being irradiated onto the graphene/GQD/graphene photodetector according to an exemplary embodiment of the invention while increasing an applied voltage.

### [BEST MODES FOR CARRYING OUT THE INVENTION]

Advantages and features of the invention and methods of accomplishing the same may be understood more readily by reference to the following detailed description of exemplary embodiments and the accompanying drawings. The invention may, however, be embodied in many different provides and should not be construed as being limited to the embodiments set forth herein. Rather, these embodiments are provided so that this disclosure will be thorough and complete and will fully convey the concept of the invention to those skilled in the art, and the invention will only be defined by the appended claims. Like reference numerals refer to like elements throughout the specification.

Spatially relative terms, such as "beneath", "below", "lower", "under", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. In an exemplary embodiment, when the device in the figures is turned over, elements described as "below" or "beneath" or "under" other elements or features would then be oriented "above" the other elements or features. Thus, the exemplary terms "below" and "under" can encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and/or the specification and will not be interpreted in an idealized or overly formal sense unless expressly so defined herein.

According to an aspect of the invention, a graphene photodetector includes a first graphene; a graphene quantum dot (GQD) layer formed on the first graphene and including a plurality of GQDs; and a second graphene provided on the GQD layer.

According to another aspect of the invention, a manufacturing method of a GQD photodetector, includes: forming a first graphene; forming a GQD layer, including GQDs, on the first graphene; and forming a second graphene on the GQD layer so as to fabricate a "first graphene/GQD layer/second graphene" structure.

Graphene may be prepared by mechanical exfoliation, chemical vapor deposition (CVD) or epitaxial growth. The prepared graphene may be transferred onto a substrate, and may be fabricated into a device after being subjected to photolithography. In an exemplary embodiment of the invention, a field effect transistor (FET) device may be fabricated using graphene transferred onto a silicon oxide (SiO₂)/silicon (Si) substrate, but the invention is not limited thereto.

For example, the substrate may be a rigid substrate such as a Si substrate, a silicon-on-insulator (SOI) substrate, a gallium arsenide (GaAs) substrate, a silicon germanium (SiGe) substrate, a ceramic substrate, a quartz substrate, or a glass substrate for a display, or a flexible plastic substrate such as a polyimide substrate, a polyethylene terephthalate (PET) substrate, a polyethylene naphthalate (PEN) substrate, a polymethyl methacrylate (PMMA) substrate, a polycarbonate (PC) substrate, a polyethersulfone (PES) substrate, or a polyester substrate. In another example, the substrate may be a transparent substrate capable of transmitting light therethrough.

A first graphene may be prepared on the substrate. Graphene is a single atom-thick conductive material with a two-dimensional (2D) arrangement of carbon atoms in a honey comb lattice. Graphene is structurally and chemically stable and is an excellent conductor having a higher charge mobility higher than that of Si and capable of allowing more current than copper (Cu) to flow. In undoped graphene, conduction and valence bands meet and thus have no energy band gap therebetween. On the other hand, graphene quantum dots (GQDs) have an energy band gap. Thus, in response to light being irradiated onto GQDs, electrons and holes generated from the GQDs may flow in opposite directions on both sides of graphene, and as a result, photocurrent may be generated. In response to graphenes being used as transparent electrodes and quantum dots being inserted between the graphenes, the height or thickness of a potential barrier may be adjusted by adjusting the size of the quantum dots or the thickness of a layer of the quantum dots, and thus, thermal ions that may be generated at a low voltage or a leakage current that may be caused by tunneling may be prevented, compared to graphenes with no layer of quantum dots therebetween. Accordingly, a graphene/GQD layer/graphene structure is expected to provide a low dark current and a high optical responsivity. In general, in undoped graphene, the Fermi level lies at the Dirac point with zero energy. In response to light being irradiated to the graphene/GQD layer/graphene structure, electrons and holes are generated at the quantum dots. At the same time, in response to a voltage being applied to the graphenes, the Dirac point of the graphene at a high potential is moved downward, and the Dirac point of the graphene at a low potential is moved upward. As a result, photocurrent flows. Since GQDs have a low energy band gap of about 0.8 eV or less, the GQDs not only can absorb light in the near infrared (NIR) and ultraviolet (UV) wavelength ranges, but also can make a path for charge carriers, even at a relatively low voltage, by matching the Dirac point of the graphenes and the energy level of the quantum dots to each other. Since 2D materials such as GQDs enable a large number of quantum dots to be deposited per unit volume, a high optical responsivity and a high optical detectivity can be expected.

The first graphene may be prepared by various methods. For example, the first graphene may be prepared by CVD, mechanical or chemical exfoliation, epitaxial growth, and the like. Alternatively, a graphene sheet may be formed on an auxiliary substrate such as a polydimethylsiloxane (PDMS) substrate, and may then be transferred onto the substrate. Still alternatively, the first graphene may be formed by transferring graphene onto the substrate through the injection of carbon ions into a metal using an ion implantation method, subjecting the substrate to thermal treatment and cooling so as to grow the graphene on a metal, coating the grown graphene on the metal with a supporting film, removing the metal coated with the supporting film using an etchant, and transferring the graphene covered with the supporting film onto the substrate.

To transfer graphene formed on the surface of a metal to another substrate, a supporting film may be used as moving means. For example, a PMMA film or a PDMS film may be used as the supporting film, but the invention is not limited thereto. A PMMA or PDMS film may be deposited on a graphene grown on a metal, i.e., a graphene/metal layer, and before being transferred onto a target substrate, the graphene/metal layer may be soaked in an etchant in order to remove the metal.

Graphene quantum dots may be prepared on the first graphene. The GQDs may include GQDs of various sizes. The size and shape of the GQDs may be modified by obtaining a graphene oxide sheet from graphite using Hummers' method, obtaining quantum dots of various sizes from various compounds through repeated oxidation and reduction processes and using a thermal treatment method, and filtering the quantum dots of various sizes using a nano-structure membrane. Accordingly, quantum dots can be fabricated in in a uniform size and shape.

A solution mixture containing GQDs of various sizes may be dropped onto the graphene transferred on the substrate by using a pipette, and then the GQDs may be uniformly distributed using a spin coater. Various solution mixtures may be used. More specifically, a distilled water mixture may be used.

The uniformly-distributed GQD mixture is subjected to thermal treatment in the atmosphere to remove moisture. As a result, the graphene may be coated with the GQDs.

In a case when the GQD mixture is treated only once in the aforementioned manner, the thickness of a layer of the GQDs formed may not be sufficiently thick. Thus, the foregoing processes may be performed repeatedly so as to adjust the thickness of a layer of the GQDs.

A layer of the GQDs may have a thickness of 50-150 nm or 70-130 nm, and particularly, 80-120 nm. The GQDs have an amine-based functional group attached thereto. For example, alkyl amine, aniline, or polyethylene glycol (PEG) may be attached to the GQDs. The energy level of the GQDs may vary depending on the size and shape of the GQDs. Accordingly, the band gap of the GQDs may be adjusted by adjusting the size and shape of the GQDs.

For example, the GQDs may have a circular or almost circular shape. Alternatively, the GQDs may have an oval shape or a combination of a rectangular shape or a circular shape. Still alternatively, the GQDs may have a hexagonal shape. However, the invention is not limited to these examples. That is, the GQDs may have various shapes, other than those set forth herein, for example, a polygonal shape such as a rectangular shape or a pentagonal shape.

A second graphene is transferred onto the GQDs.

The second graphene may be formed on a layer of the GQDs in various manners. For example, the second graphene may be formed by CVD, mechanical or chemical exfoliation, epitaxial growth, and the like. Alternatively, a graphene sheet may be formed on an auxiliary substrate such as a PDMS substrate, and may then be transferred onto the substrate. Still alternatively, the second graphene, like the first graphene, may be formed by an ion implantation method.

Contact electrodes may be provided at the bottom of the first graphene and the top of the second graphene to apply voltages to the first and second graphenes. The contact electrodes may be coupled to the first and second graphenes through deposition or coating. The contact electrodes may be formed using various metals, for example, silver (Ag), gold (Au), aluminum (Al), and the like.

The photocurrent properties of a GQD photodetector may be determined by applying voltage while irradiating light from above the second graphene. The term "forward voltage", as used herein, may indicate a positive voltage applied to the upper graphene with respect to the lower graphene.

For example, a xenon lamp may be used as a light source for measuring the optical responsivity of a GQD photodetector, and the photocurrent properties of the GQD photodetector may be identified by measuring photocurrent while irradiating monochromatic light obtained by monochrometer onto the upper graphene of the GQD photodetector. Also, the spectral responsivity of the GQD photodetector may be identified by measuring the intensity of monochromatic light extracted by the monochrometer in the form of a current-to-voltage ratio corresponding to each wavelength.

### EXAMPLES

### 1. Preparation Example 1: Preparation of Graphene

A large-scale graphene was fabricated using CVD. More specifically, Cu to be used as a catalyst layer, was deposited on a substrate, and the substrate was reacted with a mixed gas of methane and hydrogen at a high temperature of about 1000(°C?) so as for an appropriate amount of carbon to be dissolved or absorbed into the catalyst layer. Thereafter, the substrate was cooled so as to crystallize the carbon atoms in the catalyst layer and thus to form a graphene crystalline structure. Graphene synthesized in this manner may be removed from the substrate by removing the catalyst layer, and may be used for a desired purpose. The fabrication and the transfer of graphene are already disclosed in the prior art [J. Appl. Phys. 113, 064305 (2013)].

### 2. Preparation Example 1: Preparation of GQDs

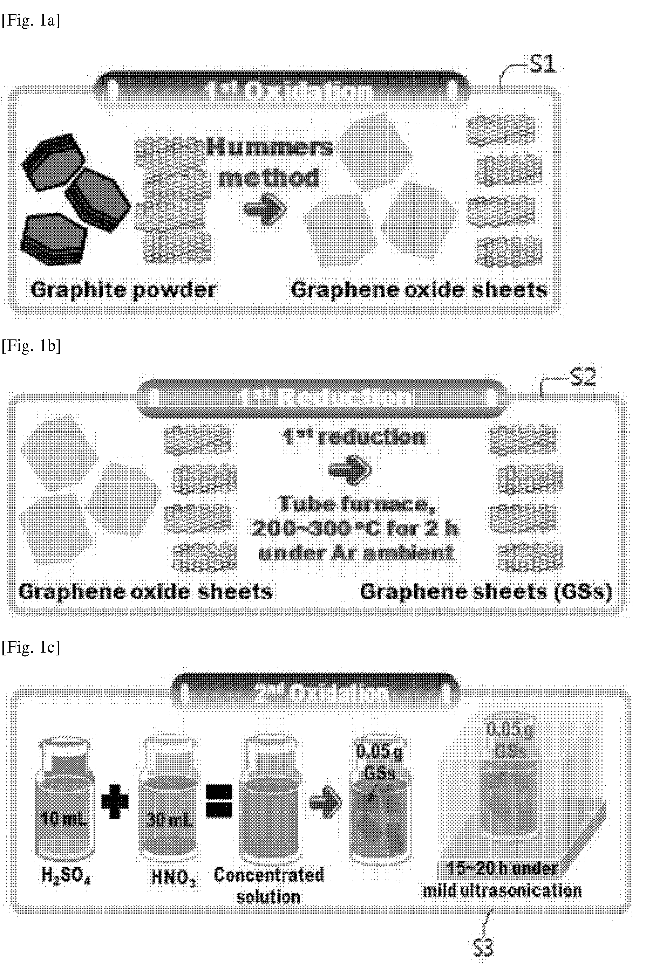

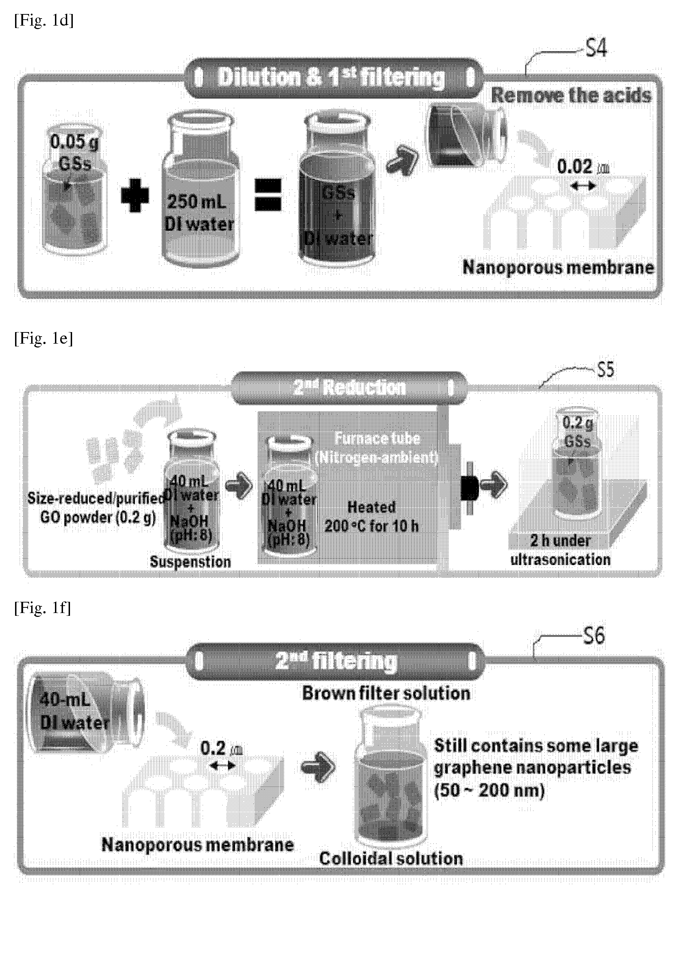

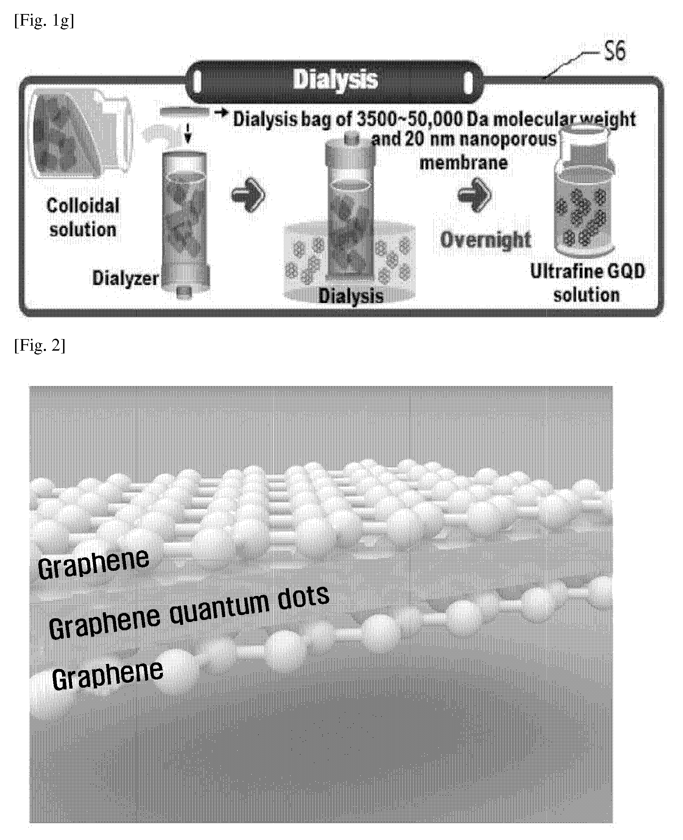

(1) In S1, i.e., the step of performing a primary oxidation process, graphene oxide sheets were obtained from graphite powder using a modified Hummers method (see FIG. 1a).
(2) In S2, i.e., the step of performing a reduction process, graphene powder having a size of several hundreds of nanometers to several micrometers and having oxygen removed therefrom by thermal treatment performed for two hours at a temperature of 200°C to 300°C in an argon atmosphere was obtained (see FIG. 1b).
(3) As illustrated in FIG. 1C, in S3, i.e., the step of performing a secondary oxidation process, a well-refined graphene oxide solution was obtained by mixing 0.05g of the graphene powder obtained by the primary oxidation process and the reduction process with a strong acid and oxidant compounds such as H₂SO₄ and HNO₃, and dispersing the mixture in an ultrasonic cleaner for 15 to 20 hours (see FIG. 1c).
(4) In S4, i.e., the step of performing dilution and first filtering processes, 250 ml of distilled water was added to dilute the graphene oxide solution, and filtering was performed using a nanoporous membrane(pore size: 0.02 *µ*m) to eliminate the diluted graphene oxide solution (see FIG. 1d).
(5) In S5, i.e., the step of performing a secondary reduction process, graphene nano particles was obtained through the reduction of graphene oxide by dispersing 0.2g of refined graphene oxide powder again in 40 ml of distilled water, using NaOH to achieve a pH of 8, and subjecting the resulting suspension to thermal treatment for 10 hours at a temperature of 250°C in a nitrogen atmosphere (see FIG. 1e).
(6) In S6, i.e., the step of performing a secondary filtering process, a brown filter solution was separated by lowering the temperature to room temperature and performing filtering using a nanoporous membrane(pore size: 0.2 *µ*m). The solution obtained in S6 exhibited bluish fluorescence because of the presence of large graphene particles (particle size: 50 nm to 200 nm) (see FIG. 1f).
(7) In S7, i.e., the step of performing a dialysis process, refined GQDs that were uniform and homogeneous were obtained by performing a dialysis process using a dialysis bag with a molecular weight of 3,500-50,000 daltons and a nanoporous membrane(pore size: 20nm) so as to separate quantum dots of uniform size from the solution containing GQDs of various sizes, obtained in S6 (see FIG. 1g).

3. Preparation Example 3: Fabrication of GQD Photodetector

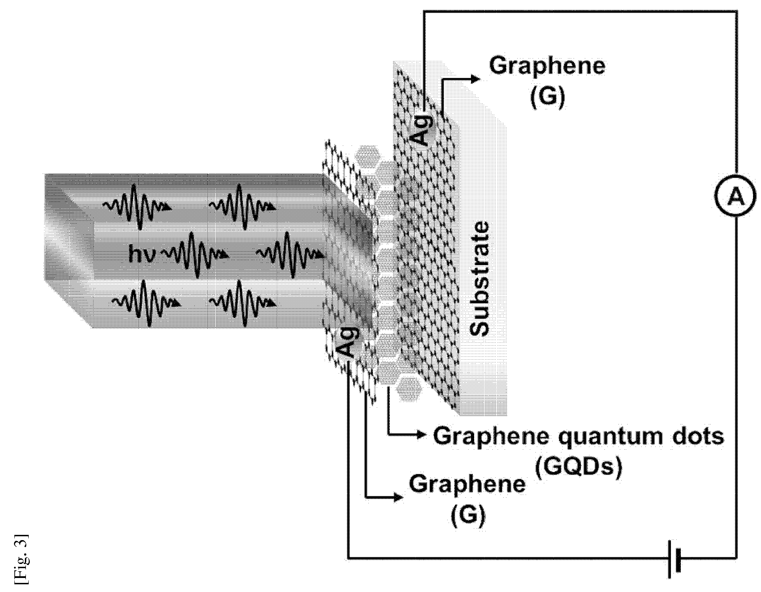

A GQD photodetector having a graphene/GQD/graphene structure, as illustrated in FIG. 2, was fabricated, and the detailed processes are as follows.
(1) Graphene obtained by CVD was transferred onto a 300 nm-SiO₂/Si substrate.
(2) A distilled water mixture containing GQDs of various sizes was dropped onto the graphene using a pipette, and a spin coater was used to uniformly distribute the GQDs. Thereafter, the graphene was subjected to thermal treatment for one hour at a temperature of about 100°C in the atmosphere to remove moisture, and was thus coated with the GQDs. A thickness of a layer of the GQDs was about 100 nm.
(3) After the coating of the lower graphene with the GQDs, upper graphene was transferred onto only part of the lower graphene coated with the GQDs. The GQDs were applied over an area with a size of 0.5×0.5 cm² on the lower graphene with a size of 1×1 cm², and the upper graphene was transferred onto the GQDs. After the transfer of the upper graphene, the substrate was subjected to thermal treatment for one hour at a temperature of 100°C in the atmosphere to improve the bonding between the g raphenes and the GQDs.
(4) Contact electrodes were formed at the top and the bottom of the resulting structure through deposition or coating (using Ag, Au, Al, or the like) to apply voltages to the upper and lower graphenes.
(5) By using the resulting structure, a circuit was configured, as illustrated in FIG. 3, and the photocurrent properties of the circuit according to an applied voltage was evaluated by irradiating light onto the upper graphene. The term "forward voltage", as used herein, may indicate a positive voltage applied to the upper graphene with respect to the lower graphene.

### 4. Experimental Example 1: Evaluation of Photoluminescence of GQD Photodetector

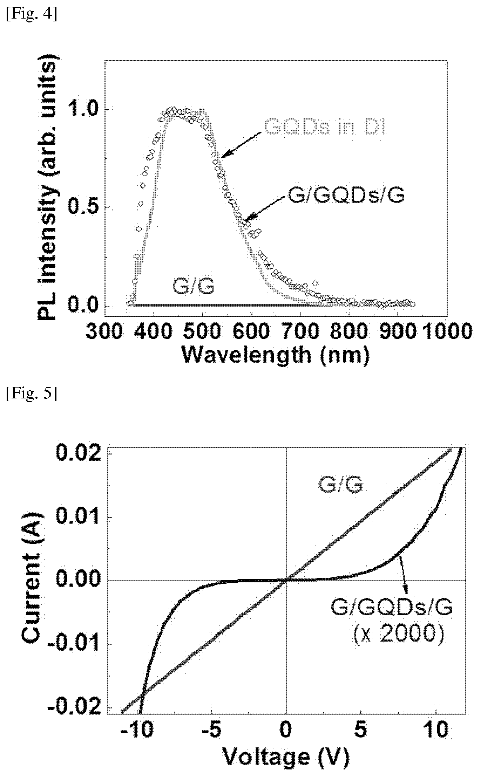

Referring to FIG. 4, a graphene/graphene sample "G/G" had no photoluminescence PL because graphene has no energy band gap. However, it is well known that GQDs have a wide PL spectrum ranging from 350 nm to 700 nm. The PL spectrum of GQDs in DI water "GQDs in DI" had a peak at about 430 nm and was observed over a wide wavelength range, and a similar PL spectrum was observed from a graphene/GQD/graphene sample "G/GQD/G", indicating the presence of GQDs properly inserted between the graphenes.

### 5. Experimental Example 2: Current-Voltage Curve of GQD Photodetector

Referring to FIG. 5, the graphene/graphene sample "G/G" with no quantum dots resulted in a very high dark current (of about 0.01 A) due to the Klein tunneling effect, and the voltage-current variation of the graphene/graphene sample "G/G" was highly linear and symmetrical for forward and backward voltages. On the other hand, the graphene/GQD/graphene sample "G/GQD/G" showed an asymmetric voltage-current variation with regard to the forward and backward voltages, and exhibited the properties of a diode, i.e., allowing a current to flow rapidly at a voltage higher than a predefined level.

### 6. Experimental Example 3: Current-Voltage Curve of GQD Photodetector for Incident Energy

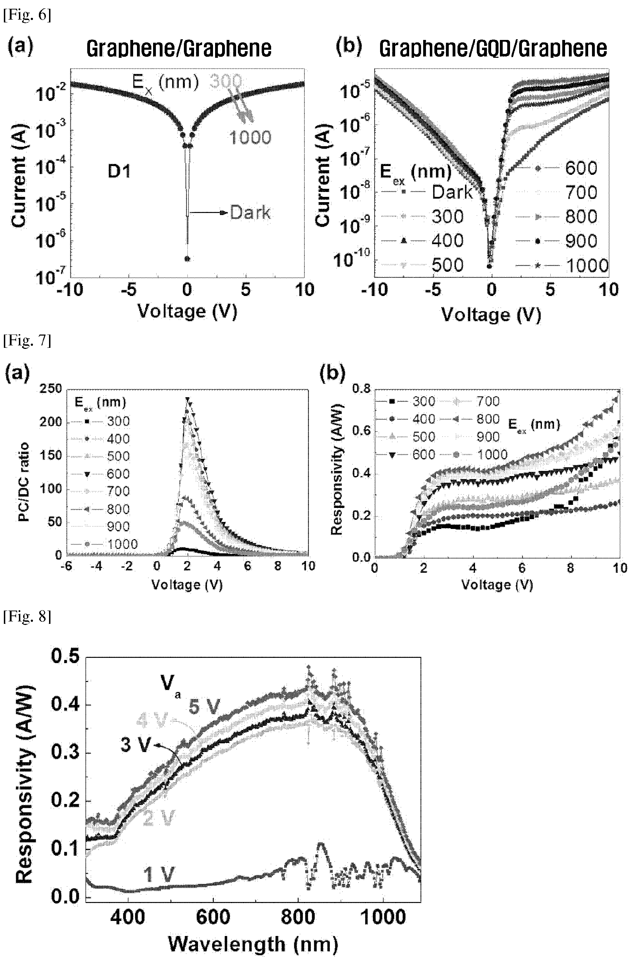

Referring to FIG. 6(a), even though light of various wavelengths from 300 nm to 1000 nm was irradiated, no photocurrent was detected from a graphene/graphene structure with no quantum dots for both forward and backward voltages because of a very high dark current. On the other hand, referring to FIG. 6(b), in response to light of various wavelengths being irradiated to a graphene/GQD/graphene structure, a photoreaction occurred for both backward and forward voltages, in which case, the intensity of the photocurrent generated in response to the application of the forward voltage was much higher than the intensity of the photocurrent generated in response to the application of the backward voltage.

### 7. Experimental Example 4: Measurement of Photocurrent-to-Dark Current Ratio and Optical Responsivity of GQD Photodetector

A xenon lamp was used as a light source for measuring the optical responsivity of a GQD photodetector, and the photocurrent properties of the GQD photodetector was identified by measuring photocurrent while irradiating monochromatic light obtained by monochrometer onto the upper graphene of the GQD photodetector. Also, the spectral responsivity of the GQD photodetector was identified by measuring the intensity of monochromatic light extracted by the monochrometer in the form of a current-to-voltage ratio corresponding to each wavelength.

Referring to FIG. 7(a), the dark current-to-photocurrent ratio of the GQD photodetector was measured for different incident wavelengths. When the applied voltage to the GQD photodetector was about 2 V, the dark current-to-photocurrent ratio of the GQD photodetector reached its peak for all incident wavelengths. The dark current-to-photocurrent ratio of the GQD photodetector for an incident wavelength of 600 nm was 235 or higher. A driving voltage for a Si photodetector is generally -15 V, and a driving voltage for the GQD photodetector is much lower than the driving voltage for a Si photodetector.

Referring to FIG. 7(b), the optical responsivity of the GQD photodetector was measured for different applied voltages. The GQD photodetector exhibited the highest optical responsivity for incident light of 800 nm. More specifically, when a wavelength of 800 nm was applied, the optical responsivity of the GQD photodetector considerably increased from 0.01 A/W to 0.33 A/W in accordance with an increase of the applied voltage from 1 V to 2 V. However, when the applied voltage is further increased, the rate at which the optical responsivity of the GQD photodetector increases decreased.

### 8. Experimental Example 5: Measurement of Spectral Response of GQD Photodetector

FIG. 8 is a graph showing the spectral responsivity of a graphene/GQD/graphene photodetector according to an exemplary embodiment of the invention.

The GQD photodetector showed optical responsivity over a wide wavelength range from 350 nm to 1100 nm.

More specifically, as the applied voltage increased from 1 V to 2 V, the spectral responsivity of the GQD photodetector sharply increased. Then, for an applied voltage of higher than 2 V, the spectral responsivity of the GQD photodetector gradually increased. The optical responsivity of the GQD photodetector linearly increased from 0.2 A/W to 0.43 A/W at a given voltage as the wavelength of incident light increased from 400 nm to 800 nm, slightly decreased for incident light of 800 nm to 900 nm, and sharply decreased for incident light of 900 nm or higher.

### 9. Experimental Example 6: Measurement of External Quantum Efficiency of GQD Photodetector

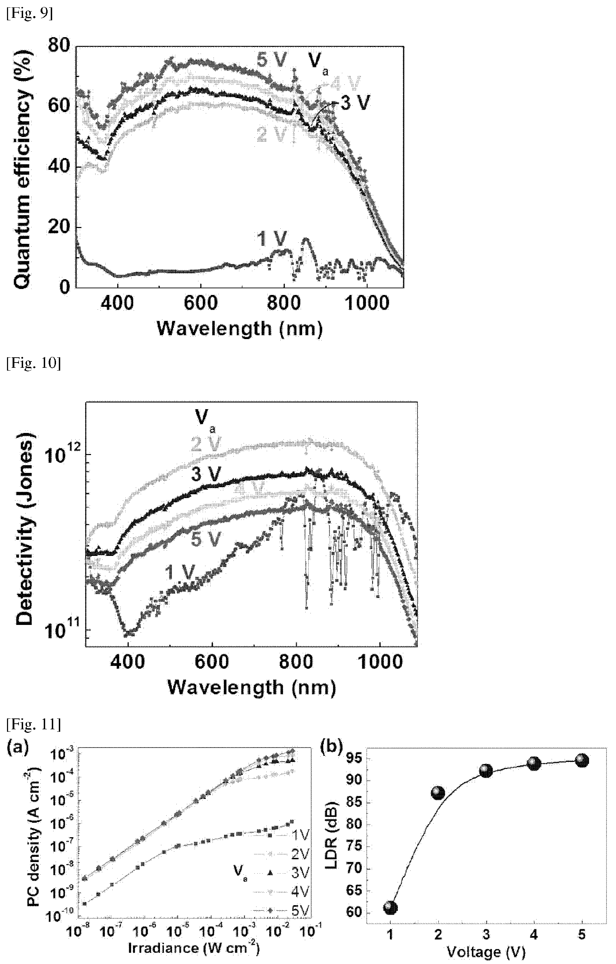

FIG. 9 is a graph showing the external quantum efficiency of the graphene/GQD/graphene photodetector according to an exemplary embodiment of the invention.

As the applied voltage increased, the external quantum efficiency of the GQD photodetector increased accordingly. For an applied voltage of 5 V, the GQD photodetector showed an excellent external quantum efficiency of 60% or higher throughout most of the UV to visible wavelength range.

### 10. Experimental Example 7: Measurement of Detectivity of GQD photodetector

FIG. 10 is a graph showing the detectivity of the graphene/GQD/graphene photodetector according to an exemplary embodiment of the invention.

The GQD photodetector showed a detectivity of 10¹¹ Jones to 10¹² Jones for all the applied voltage over a wavelength range from UV to NIR, and this detectivity range is higher than the detectivity (< 10¹¹ Jones) of related-art photodetectors using well-known nano-structurers or thin films. The detectivity of the GQD photodetector reached its maximum when the applied voltage was 2 V, which can be interpreted that the detectivity of the GQD photodetector can be maximized even at a low applied voltage.

### 11. Experimental Example 8: Measurement of Operating range of GQD photodetector

FIG. 11 is a graph showing the operating range of the graphene/GQD/graphene p hotodetector according to an exemplary embodiment of the invention.

Referring to FIG. 11 (a), in order to determine the linear dynamic range (LDR) of the GQD photodetector, the amount of photocurrent was measured from the GQD photodetector while changing the intensity of laser light of 532 nm. As the intensity of the laser light increased, the amount of photocurrent linearly increased with a slope close to 1.

As the applied voltage increased, the range of laser intensities capable of linearly increasing the amount of photocurrent increased. The optical response of the GQD photodetector was uniformly maintained, rather than decreasing, regardless of the intensity of the laser light.

The LDR of the GQD Photodetector was 61 dB for an applied voltage of 1 V, 87 dB for an applied voltage of 2 V, 92 dB for an applied voltage of 3 V, 94 dB for an applied voltage of 4 V, and 95 dB for an applied voltage of 5 V.

### 12. Experimental Example 9: Measurement of 3-dB Frequency of GQD Photodetector

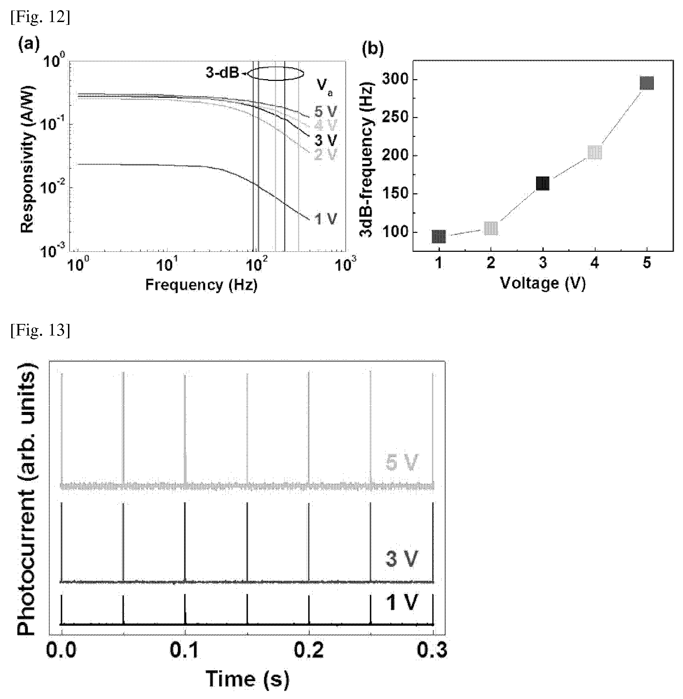

FIG. 12 is a graph showing the optical responsivity of the graphene/GQD/graphene photodetector according to an exemplary embodiment of the invention according to a 3-dB frequency.

Referring to FIG. 12(a), the operating range of the GQD photodetector at each frequency was determined by measuring the optical responsivity to the frequency of a light source of the GQD photodetector. An operating range at a frequency derived from the optical responsivity to the variation of the frequency of incident light of the GQD photodetector according to Preparation Example 3 was identified, and was found to appear in the 3-dB bandwidth. Referring to FIG. 12(b), the 3-dB frequency of the GQD photodetector at each applied voltage was measured. As the applied voltage increased from 1 V to 5 V, the 3-dB frequency of the GQD photodetector increased from 94 Hz to 295 Hz.

### 13. Experimental Example 10: Measurement of Photodetection Stability of GQD Photodetector

FIG. 13 is a graph showing the periodic variation of photocurrent according to pulse laser light periodically incident upon the graphene/GQD/graphene photodetector according to an exemplary embodiment of the invention.

The periodic variation of photocurrent in the GQD photodetector was measured using 532 nm-pulse laser light (20 ps, 20 Hz) as incident light while varying the applied voltage from 1 V to 3 V to 5 V. As a result, the GQD photodetector produced the same peaks even in response to the repeated irradiation of pulse light thereto, regardless of the variation of the applied voltage. Also, whenever a pulse was applied, the GQD photodetector generated photocurrent, and the amount of the photocurrent was uniform. Accordingly, it can be said that the GQD photodetector is stably operable.

### 14. Experimental Example 11: Measurement of Response Time of GQD Photodetector

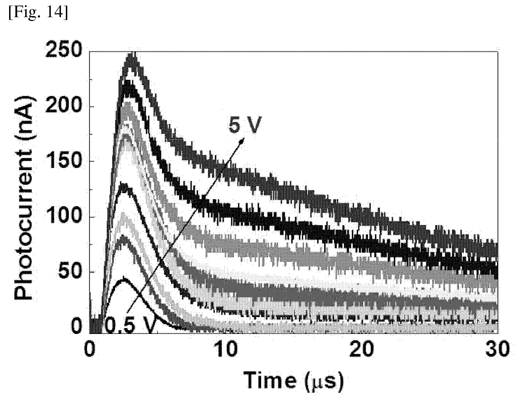

FIG. 14 is a graph showing the variation of photocurrent over a short period of time in response to pulse laser light being irradiated onto the graphene/GQD/graphene photodetector according to an exemplary embodiment of the invention while increasing an applied voltage.

The response time of photocurrent for each applied voltage was measured. More specifically, the rise time and decay time of photocurrent were measured while increasing the applied voltage from 0.5 to 5 V by 0.5 V each time.

The intensity of photocurrent increased according to the applied voltage, but it was found that the GQD photodetector has a very fast photocurrent rise time of several hundreds of nanoseconds and a much slower photocurrent decay time of dozens of seconds.

Although preferred embodiments of the invention have been described for illustrative purposes, those skilled in the art will appreciate that various modifications, additions and substitutions are possible, without departing from the scope and spirit of the invention as disclosed in the accompanying claims.

## Claims

1. A graphene photodetector, comprising:
a first graphene;
a graphene quantum dot (GQD) layer formed on the first graphene and including a plurality of GQDs; and
a second graphene provided on the GQD layer.

2. The graphene photodetector of claim 1, wherein the first and second graphenes are undoped graphenes.

3. The graphene photodetector of claim 1, wherein the GQD layer has a thickness of 50 nm to 150 nm.

4. The graphene photodetector of claim 1, further comprising:
contact electrodes provided on the first and second graphenes, respectively.

5. The graphene photodetector of claim 4, wherein the contact electrodes are silver (Ag), gold (Au), or aluminum (Al).

6. A manufacturing method of a GQD photodetector, comprising:
forming a first graphene;
forming a GQD layer, including GQDs, on the first graphene; and
forming a second graphene on the GQD layer so as to fabricate a "first graphene/GQD layer/second graphene" structure.

7. The manufacturing method of claim 6, wherein the forming the first graphene, comprises forming the first graphene in a same method used to form graphene on a substrate.

8. The manufacturing method of claim 6, wherein the forming the GQD layer, comprises applying a solution containing GQDs onto the first graphene and removing moisture through thermal treatment.

9. The manufacturing method of claim 6, wherein the GQD layer has a thickness of 50 nm to 150 nm.

10. The manufacturing method of claim 6, further comprising:
subjecting the "first graphene/GQD layer/second graphene" structure to thermal treatment at a temperature of 150°C to 250°C.

11. The manufacturing method of claim 6, further comprising:
depositing or coating contact electrodes on the first and second graphenes, respectively.
